# EUROPÄISCHE PATENTSCHRIFT

(11) **EP 0 355 015 B1**
(45) Veröffentlichungstag und Bekanntmachung des Hinweises auf die Patenterteilung: **19.01.1994**
(21) Anmeldenummer: 89114813.2
(22) Anmeldetag: 10.08.1989
(51) Int. Cl.: G03F 7/32

(54) **Verfahren zur Entwicklung positiv arbeitender Photoresists**
Process for developing positively acting photoresists
Procédé pour révéler des photoréserves positives

(30) Priorität: 13.08.1988 DE 3827567
(43) Veröffentlichungstag der Anmeldung: 21.02.1990
(73) Patentinhaber: BASF Aktiengesellschaft, 67063 Ludwigshafen (DE)
(72) Erfinder: Schwalm, Reinhold, Dr., D-6706 Wachenheim (DE); Binder, Horst, D-6840 Lampertheim (DE)

(56) Entgegenhaltungen:
- EP-A- 0 080 042
- EP-A- 0 336 400
- WO-A-87/07039
- GB-A- 2 193 335

## Beschreibung

Die Erfindung betrifft ein Verfahren zur Entwicklung positiv arbeitender Photoresists unter Verwendung einer wäßrigen Lösung bestimmter basischer Verbindungen, das hervorragende Eigenschaften hinsichtlich Kontrast, Kantensteilheit und Auflösung ergibt.

Zur selektiven Veränderung von kleinen Bereichen in einem Substrat verwendet man in der Halbleitertechnik Photoresists als Hilfsschicht. Dazu werden bevorzugt positiv arbeitende Photoresists eingesetzt. Mit Hilfe der Photoresists lassen sich Reliefmuster herstellen, die an bestimmten Stellen die zu verändernde Oberfläche freilegen und sie damit weiterer Behandlung, wie Dotierung oder Metallisierung zugänglich machen.

Positiv-Resistmuster werden erzeugt, indem eine Schicht eines lichtempfindlichen Materials auf einen Siliziumwafer aufgebracht, anschließend durch eine strukturierte Maske belichtet und im Entwicklungsprozeß die belichteten Bereiche selektiv herausgelöst werden.

Übliche lichtempfindliche Zusammensetzungen sind solche aus alkalilöslichen Harzen, z.B. vom Novolaktyp, und einer photoempfindlichen Komponente, beispielsweise einem o-Chinondiazid. Durch die Einwirkung von UV-Licht wird die Löslichkeit der Zusammensetzung in alkalischen Entwicklern in den belichteten Bereichen drastisch erhöht.

Übliche Entwickler sind wäßrig-alkalische Lösungen auf Basis von Natriumhydroxid, Kaliumhydroxyd oder Natriumsilikat. Eine Reihe von metallionenfreien Entwicklern auf Basis von Ammoniumhydroxyden, wie Tetramethylammoniumhydroxyd oder Tetraethylammoniumhydroxyd ist ebenfalls bekannt (vgl. z.B. EP-A-124 297). Um den Kontrast dieser Systeme zu erhöhen hat man beispielsweise Tenside zugesetzt, meist quarternäre Ammoniumtenside in Kombination mit Ammoniumhydroxydentwicklern bzw. fluorierte nichtionische Tenside in Kombination mit Alkalihydroxydentwicklern (vgl. EP-A-146 834 und EP-A-231 028). Diese Tenside ergeben einen hohen Kontrast, jedoch ist die Reproduzierbarkeit bei der Tauchentwicklung schlecht, da die Tenside schnell verbraucht werden und damit die Entwicklerstabilität verschlechtern.

Wünschenswert ist daher ein Verfahren zur Entwicklung positiv arbeitender Photoresists, das bei genügender Stabilität des wäßrig-alkischen Entwicklers einen hohen Kontrast ermöglicht.

Aufgabe der vorliegenden Erfindung ist es, ein Verfahren zur Entwicklung von Positivphotoresists auf Basis Poly(p-hydroxystyrol)/Sulfoniumsalz zur Verfügung zu stellen, das einen hohen Kontrast, hohe Auflösung und gute Strukturqualität ermöglicht, sowie hinsichtlich Stabilität und Entwicklungskapazität des Entwicklers verbesserte Eigenschaften aufweist.

Überraschenderweise wurde nun gefunden, daß sich zur Entwicklung von Positivresists auf Basis Poly(p-hydroxystyrol)/Sulfoniumsalz eine wäßrige Lösung von Hydroxyalkylpiperidin besonders gut eignet, genügende Stabilität aufweist und ausgezeichnete Entwicklungseigenschaften ergibt.

Gegenstand der vorliegenden Erfindung ist ein Verfahren zur Entwicklung eines positiv arbeitenden Photoresists auf Basis Poly-(p-hydroxystyrol)/Sulfoniumsalz, wobei der Resist auf ein Substrat aufgebracht und bildmäßig belichtet sowie zur Bildung des positiven Resistmusters mit einer mindestens eine wasserlösliche basische Verbindung enthaltenden wäßrigen Entwicklerlösung in Kontakt gebracht wird, dadurch gekennzeichnet, daß die wäßrige Entwicklerlösung als wasserlösliche basische Verbindung eine Verbindung der allgemeinen Formel (I) enthält, 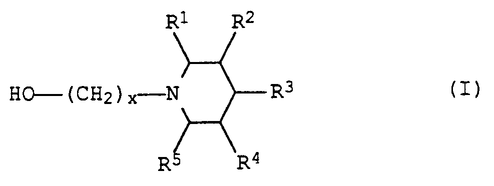
worin R¹ bis R⁵ untereinander gleich oder verschieden sind und für H, OH, Hydroxyalkyl mit 1 bis 4 Kohlenstoffatomen, Alkoxi mit 1 bis 4 Kohlenstoffatomen oder Alkyl mit 1 bis 4 Kohlenstoffatomen stehen und x = 1 bis 5 ist.

Die für das erfindungsgemäße Verfahren einzusetzende Entwicklerlösung kann zusätzlich noch eine nichtionische oberflächenaktive Substanz enthalten und enthält vorzugsweise 5 bis 50, insbesondere 10 bis 40 Gew.%, bezogen auf die Gesamtmenge der Entwicklerlösung, einer Verbindung der Formel (I).

Besonders bevorzugte Hydroxyalkylpiperidine gemäß der allgemeinen Formel (I) sind N-Hydroxymethyl-, N-Hydroxyethyl- und N-Hydroxypropylpiperidin.

Die für das erfindungsgemäße Verfahren eingesetzten Entwicklerlösungen sind hinsichtlich Stabilität und Entwicklungskapazität verbessert. Es lassen sich damit hervorragende Eigenschaften in Kontrast, Kantensteilheit und Auflösung erzielen.

Nach dem erfindungsgemäßen Verfahren können prinzipiell alle Positivphotoresistmaterialien entwickelt werden, die im wesentlichen auf Gemischen von phenolischen Harzen als basenlöslicher Matrix und einer photoempfindlichen Komponente gemäß Anspruch 1 basieren.

Einen Überblick über die Verwendung von Novolaken in Positiv Resists gibt T. Pampalone in "Solid State Technology, June 1984, Seiten 115 bis 120". Die Verwendung von Novolaken auf Basis von p-Kresol-Formaldehyd-Harzen für die Deep-UV Lithographie zeigt E. Gipstein in "J. Electrochemical Soc., 129, 1, Seiten 201 bis 205 (1982).

Besonders geeignet ist das erfindungsgemäße Verfahren zur Entwicklung von Positivresists, basierend auf den in DE-A-37 21 741 beschriebenen Systemen aus phenolischen Polymeren und sulfoniumsalzen mit säurelabilen Gruppen.

Bevorzugte sulfoniumsalze sind dabei Sulfoniumsalze der allgemeinen Formel (II): 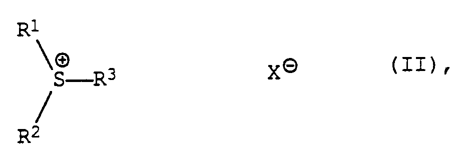
worin R¹ bis R³ untereinander gleich oder verschieden sind und aromatische und/oder aliphatische Reste, die gegebenenfalls Heteroatome enthalten, enthalten können, mit der Maßgabe, daß mindestens einer der Reste R¹ bis R³ eine säurespaltbare Gruppe, beispielsweise t-Butylcarbonate von Phenolen bzw. Silylether von Phenolen, enthält. Die vorgenannten säurelabilen Gruppen sind bevorzugt, jedoch können eine große Zahl weiterer säurelabiler Gruppen, wie die bekannten Tetrahydropyranylether, Orthoester, Trityl- und Benzylgruppen, sowie t-Butylester von Carbonsäuren ebenfalls verwendet werden. Es können auch zwei oder mehrere Sulfoniumeinheiten im Molekül über die Reste R¹ bis R³ verknüpft sein.

Als Gegenionen X^{⊖} kommen bevorzugt komplexe Metallhalogenide, wie Tetrafluorborat, Hexafluoroantimonat, Hexafluoroarsenat und Hexafluorophosphat in Betracht.

Das phenolische Polymere enthält im allgemeinen Einheiten der allgemeinen Formel (III) 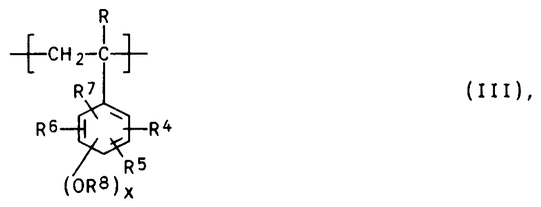
: worin R ein Wasserstoff- oder Halogenatom oder eine Alkylgruppe mit 1 bis 4 Kohlenstoffatomen, R⁴, R⁵, R⁶, R⁷ Wasserstoff-, Halogen, Alkyl- oder Alkoxigruppen mit jeweils 1 bis 4 Kohlenstoffatomen, R⁸ Wasserstoff oder eine säurelabile Gruppe, wie Trimethylsilyl, t-Butoxycarbonyl, Isopropyloxicarbonyl oder Tetrahydropyranyl bedeuten und x eine Zahl von 1 bis 3, vorzugsweise 1 ist.

Die Polymerisate der Formel (III), bei der R Wasserstoff oder Methyl ist, sowie R⁴ bis R⁷ Wasserstoff und R⁸ Wasserstoff und/oder eine säurelabile Gruppe der vorgenannten Bedeutung ist, enthalten -O-R⁸ in p-Stellung und der Anteil der Gruppen mit R⁸ = Wasserstoff beträgt mindestens 70 mol%.

Diese Polymeren haben im allgemeinen mittlere Molekulargewichte (M̅ₙ) im Bereich von 1 000 bis 250 000, bevorzugt 10 000 bis 80 000 und sind im allgemeinen mit einem Anteil zwischen 40 und 98, vorzugsweise 60 bis 95 Gew.% im strahlungsempfindlichen Gemisch enthalten.

Als polymere Bindemittel können vorteilhafterweise auch Gemische alkalisch löslicher Polymerer eingesetzt werden, die einen hohen Anteil aromatischer Gruppen enthalten, nämlich Novolake und substituierte Poly-(p-hydroxystyrole). Bindemittel mit einem hohen aromatischen Anteil haben den Vorteil, daß sie relativ stabil in Plasma- und reaktiven Ionenätzverfahren sind.

Für die spezielle Anwendung in der Deep-UV Lithographie kann es notwendig sein, daß das strahlungsempfindliche Gemisch sowohl ein phenolisches Polymerisat auf Basis von Polyvinylphenol als auch einen Novolak vom Typ p-Kresol-Formaldehyd oder überwiegend o,o'-verknüpftem Phenol-Formaldehyd enthält, da einer dieser Komponenten allein oft nicht alle erwünschten Eigenschaften ergibt.

Das erfindungsgemäße Verfahren zur Erzeugung von Reliefmustern wird in bekannter Weise durchgeführt, jedoch unter Verwendung des erfindungsgemäßen Entwicklers. Dazu werden die Gemische aus phenolischem Harz und/oder phenolischem Polymerisat und photoempfindlicher Komponente im allgemeinen in einem organischen Lösungsmittel gelöst, wobei der Feststoffgehalt im Bereich zwischen 5 und 40 Gew.% liegt. Als Lösungsmittel kommen bevorzugt aliphatische Ketone, Ether und Ester, sowie Mischungen derselben in Frage. Besonders bevorzugt sind Alkylenglykolmonoalkylether, wie beispielsweise Ethyl-cellosolve, Butylglykol, Methyl-cellosolve und 1-Methoxy-2-propanol, Alkylenglykolalkylether-ester, wie beispielsweise Methyl-cellosolve-acetat, Ethylcellosolve-acetat, Methyl-propylen-glykol-acetat und Ethyl-propylenglykol-acetat, Ketone, wie beispielsweise Cyclohexanon, Cyclopentanon und Methyl-ethyl-keton, sowie Acetate, wie Butylacetat und Aromaten, wie Toluol und Xylol. Die Auswahl der entsprechenden Lösungsmittel, sowie deren Mischung richtet sich nach der Wahl des jeweiligen phenolischen Polymers, Novolaks und der photoempfindlichen Komponente.

Weiterhin können andere Zusätze wie Haftvermittler, Netzmittel, Farbstoffe und Weichmacher zugesetzt werden.

Gegebenenfalls können auch Sensibilisatoren in geringen Mengen zugesetzt werden, um die Verbindungen im längerwelligem UV- bis hin zum sichtbaren Bereich zu sensibilisieren. Polycyclische Aromaten, wie Pyren und Perylen sind bevorzugt, jedoch können auch andere Farbstoffe, die als Sensibilisatoren wirken, verwendet werden.

Die homogene Lösung des lichtempfindlichen Gemisches kann in üblicher Weise, beispielsweise durch Aufschleudern (spin coating) auf das zu beschichtende Substrat - im allgemeinen auf einen an der Oberfläche oxidierten Siliziumwafer - aufgetragen werden, so daß eine lichtempfindliche Schicht in einer Schichtdicke von ca. 1 - 2 µm erhalten wird und bei Temperaturen zwischen 60°C und 120°C ausgeheizt werden. Durch bildmäßige Belichtung mit Hilfe einer strukturierten Maske, wobei als Lichtquellen beispielsweise Quecksilber-Hochdrucklampen oder Excimer-Laser in Frage kommen, erzeugt man in der lichtempfindlichen Schicht ein latentes Bild. Vor dem Entwicklungsschritt kann gegebenenfalls noch ein weiteres Ausheizen (postexposure-bake) bei Temperaturen zwischen 60°C und 120°C erfolgen. Dieses "postexposure-bake" wird im stand der Technik bei den Novolak/o-Chinondiazid-Systemen zur Reduzierung der durch sogenannte "stehende Wellen" hervorgerufenen Effekte teilweise durchgeführt, bei den anmeldungs gemäß verwendeten Systemen auf Basis Poly-(p-hydroxystyrol)/Sulfoniumsalz ist jedoch ein postexposure-bake bei Temperaturen zwischen 60°C und 120°C unbedingt durchzuführen. Durch Kontaktieren der so behandelten lichtempfindlichen Schicht mit dem erfindungsgemäßen Entwickler, entweder durch Eintauchen in die Entwicklerlösung oder durch Besprühen mit Entwickler wird das latente Bild zu einem Reliefmuster entwickelt.

Ein Zusatz von oberflächenaktiven Substanzen (Tensiden) zur erfindundungsgemäßen Entwicklerlösung ist im allgemeinen nicht nötig. Es können jedoch derartige Stoffe im allgemeinen in Mengen von bis zu 5 Gewichtsprozent, bezogen auf Gesamtmenge der Entwicklerlösung, beispielsweise Nonylphenoxy-poly-(ethylenoxi)ethanol, Octylphenoxy-poly-(ethylenoxi)ethanol oder kommerziell erhältliche fluorierte Tenside zugesetzt werden.

Nach dem Behandeln mit der erfindungsgemäßen Entwicklerlösung wird das erzeugte Relief getrocknet und dient dann als Maske für die weiteren Behandlungsschritte, wie z.B. Ätzen des Substrats.

Der erfindungsgemäße Entwickler zeigt hervorragende Eigenschaften in Bezug auf die zu erzielende Auflösung (kleiner 1 µm) und Kantensteilheit, ermöglicht hohe Empfindlichkeit des Resists gegenüber kurzwelliger UV-Strahlung, zeigt gute Entwicklungskapazität und Stabilität und ist daher ideal für die Mikrolithographie zur Herstellung von Halbleiterbauelementen geeignet.

Die in den Beispielen angegebenen Teile und Prozente sind, soweit nicht anders angegeben, Gewichtsteile und Gewichtsprozente.

### Beispiel 1

Eine Fotoresistlösung, bestehend im wesentlichen aus 16 Teilen eines Poly(p-hydroxistyrols) mit einem mittleren Molekulargewicht von 25 000 (M̅ₙ aus GPC) als alkalilöslichem Bindemittel und 4 Teilen Tris-(4-t-butoxicarbonyl-oxiphenyl-)sulfonium hexafluoroarsenat als photoaktiver Komponente und 80 Teilen Methyl-propylenglykol-acetat als Lösungsmittel, wurde in einer Schichtdicke von 1,0 µm auf an der Oberfläche oxidierte Siliziumwafer aufgeschleudert und 1 Minute bei 90°C ausgeheizt. Die Belichtung der beschichteten und vorgetrockneten Siliziumwafer durch die Transmissionsmaske erfolgte mit kurzwelligem UV-Licht der Wellenlänge 248 nm im Vakuum-Kontaktverfahren. Nach einer thermischen Nachbehandlung von 1 Minute bei 100°C konnte der Siliziumwafer in 20 %iger N-(2-Hydroxiethyl)piperidinlösung vom pH 12,4 èntwickelt werden.

Folgende Restschichtdicken wurden nach dieser Entwicklung und dem Reinigungsprozeß mit deionisiertem Wasser erhalten:

| Belichtungsenergie [mJ/cm²] | Restschichtdicke [ % ] |
|---|---|
| 1,75 | 98,6 |
| 8,75 | 99,9 |
| 17,50 | 70,65 |
| 21,00 | 48,3 |
| 24,5 | 35,2 |
| 28,0 | 21,1 |
| 31,5 | 0 |
| 35,0 | 0 |
| 70 | 0 |

Die Schichtdicken wurden mit einem α-step Profilometer der Firma Tencor gemessen.

Die anschließend durchgeführten rasterelektronenmikroskopischen Untersuchungen zeigten sehr gut ausentwickelte 0,75 µm breite Strukturen mit einem sehr steilen Kantenprofil. Rückstände auf dem Wafer, die in der Halbleiterherstellung unerwünscht sind, konnten ebenfalls nicht nachgewiesen werden.

Verwendet man kommerziell erhältliche Entwickler auf Basis von Alkalihydroxiden oder Tetraalkylammoniumhydroxiden, so wird die Oberfläche der Resistmuster stark angegriffen und die erzeugten Profile sind für eine weitere Strukturübertragung (wie z.B. Ätzen) ungeeignet.

## Patentansprüche

1. Verfahren zur Entwicklung eines positiv arbeitenden Photoresists auf Basis Poly-(p-hydroxystyrol)/Sulfoniumsalz, wobei der Resist auf ein Substrat aufgebracht und bildmäßig belichtet sowie zur Bildung des positiven Resistmusters mit einer mindestens eine wasserlösliche basische Verbindung enthaltenden wäßrigen Entwicklerlösung in Kontakt gebracht wird, dadurch gekennzeichnet, daß die wäßrige Entwicklerlösung als wasserlösliche basische Verbindung eine Verbindung der allgemeinen Formel (I) enthält, 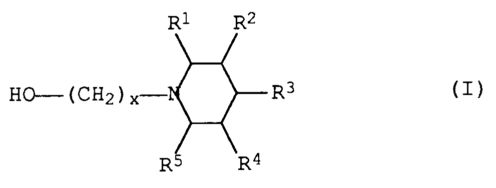 worin R¹ bis R⁵ untereinander gleich oder verschieden sind und für H, OH, Hydroxyalkyl mit 1 bis 4 Kohlenstoffatomen, Alkoxi mit 1 bis 4 Kohlenstoffatomen oder Alkyl mit 1 bis 4 Kohlenstoffatomen stehen und x = 1 bis 5 ist.

2. Verfahren nach Anspruch 1, dadurch gekennzeichnet, daß die wäßrige Entwicklerlösung zusätzlich eine nichtionische oberflächenaktive Substanz enthält.

3. Verfahren nach Anspruch 1 oder 2, dadurch gekennzeichnet, daß die wäßrige Entwicklerlösung 5 bis 50 Gew.-%, bezogen auf die Gesamtmenge der Entwicklerlösung, einer Verbindung der Formel (I) enthält.

4. Verfahren nach einem der Ansprüche 1 bis 3, dadurch gekennzeichnet, daß als Verbindung der allgemeinen Formel (I) ein Hydroxyalkylpiperidin eingesetzt wird.

5. Verfahren nach einem der vorhergehenden Ansprüche, dadurch gekennzeichnet, daß als Verbindung der allgemeinen Formel (I) N-Hydroxyethylpiperidin eingesetzt wird.

## Claims

1. A method for developing a positive-working photo-resist based on poly-(p-hydroxystyrene)/sulfonium salt, the resist being applied to a substrate, exposed imagewise and brought into contact with an aqueous developer solution which contains one or more water-soluble basic compounds to form the positive resist image, wherein the aqueous developer solution contains, as the water-soluble basic compound, a compound of the formula (I). 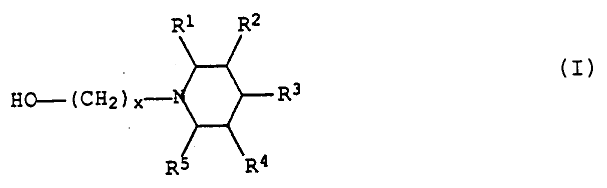 where R¹ to R⁵ are identical or different and are each H, OH, hydroxyalkyl of 1 to 4 carbon atoms, alkoxy of 1 to 4 carbon atoms or alkyl of 1 to 4 carbon atoms and x is from 1 to 5.

2. A method as claimed in claim 1, wherein the aqueous developer solution additionally contains a nonionic surfactant.

3. A method as claimed in claim 1 or 2, wherein the aqueous developer solution contains from 5 to 50% by weight, based on the total amount of the developer solution, of a compound of the formula (I).

4. A method as claimed in any of claims 1 to 3, wherein a hydroxyalkylpiperidine is used as the compound of the formula (I).

5. A method as claimed in any of the preceding claims, wherein N-hydroxyethylpiperidine is used as the compound of the formula (I).

## Revendications

1. Procédé pour le développement d'une photo réserve (résist) travaillant positivement, à base de sel de poly-(p-hydroxystyrol)/sulfonium, la réservé étant appliquée sur un substrat et éclairée selon une image, ainsi que, pour la formation de modèle de réserve, étant mise en contact avec une solution aqueuse de révélateur contenant au moins un composé basique soluble dans l'eau, caractérisé par le fait que la solution aqueuse de révélateur contient, comme composé basique soluble dans l'eau, un composé de la formule générale I 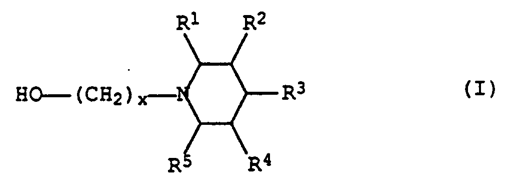 dans laquelle R¹ à R⁵ sont identiques ou différents et sont mis pour H, OH, hydroxyalkyle à 1 à 4 atomes de carbone, alcoxy à 1 à 4 atomes de carbone ou alkyle à 1 à 4 atomes de carbone et X = 1 à 5.

2. Procédé selon la revendication 1, caractérisé par le fait que le solution aqueuse de révélateur contient additionnellement une substance tensio-active non ionique.

3. Procédé selon la revendication 1 ou 2, caractérisé par le fait que la solution aqueuse contient 5 à 50 % en poids, rapportés à la quantité totale de la solution de révélateur, d'un composé de formule I.

4. Procédé selon la revendication 1 à 3, caractérisé par le fait que, comme composé de la formule générale I, on introduit une hydroxyalkylpipéridine.

5. Procédé selon l'une des revendications précédentes, caractérisé par le fait que, comme composé de la formule générale I- on introduit une N-hydroxyéthylpipéridine.
